**Europäisches Patentamt**

**European Patent Office**

**Office européen des brevets**

(11) Veröffentlichungsnummer: **0 281 651**
A1

(12) **EUROPÄISCHE PATENTANMELDUNG**

(21) Anmeldenummer: **87103443.5**

(22) Anmeldetag: **10.03.87**

(51) Int. Cl.4: **B07C 5/344** , G01R 31/28

(43) Veröffentlichungstag der Anmeldung:
**14.09.88 Patentblatt 88/37**

(84) Benannte Vertragsstaaten:
**AT CH DE FR GB IT LI NL SE**

(71) Anmelder: **Schoenelec-PFE GmbH**
**Schleissheimer Str. 22-24**
**D-8000 München 2(DE)**

(72) Erfinder: **Gerganoff, Konstantin**
**Stiftsbogen 154**
**D-8000 München 70(DE)**

(74) Vertreter: **Schütz, Peter, Dipl.-Ing. et al**
**Dr. Dieter von Bezold Dipl.-Ing. Peter Schütz**
**Dipl.-Ing. Wolfgang Heusler Brienner Strasse**
**52**
**D-8000 München 2(DE)**

(54) **Prüfvorrichtung für gegurtete elektronische Bauelemente.**

(57) Die Erfindung beschreibt eine Prüfvorrichtung für gegurtete elektronische Bauelemente mit einer Speicherstation, aus der gute Bauelemente zum Ersatz für bei der Prüfung als schlecht ermittelte Bauelemente in den Gurt eingesetzt werden. Die Speicherstation ist so ausgebildet, daß als Speicherbehälter Gurtstücke gleicher Art wie der Originalgurt verwendet werden, der beim Anwender nach Entnahme der Bauelemente als Abfall übrig bleibt. Mit der Einstellung des Transportmechanismus und Greifersupports auf unterschiedliche Gurtabmessungen wird gleichzeitig die Speicherstation so verschoben, daß das als Speicherbehälter dienende Gurtstück in die richtige Position für das jeweils an der Speicherstation befindliche Greiferelement kommt. Gleichzeitig wird eine Klebrolle zum Wiederversiegeln des Gurtes mit einem Deckband nach Prüfung der Bauelemente auf die entsprechende Gurtbreite eingestellt. Zum Erfassen einer größeren Anzahl verschiedener Gurtabmessungen kann zwischen zwei unterschiedlichen Klebrollen umgeschaltet werden. Der einfachen Umstellbarkeit auf unterschiedliche Bauelemente dient ferner ein neuartiges Kontaktsystem mit schnell auswechselbaren Kontaktkassetten, die Platinen mit gedruckten Kontakten und Leitern enthalten. In der Platine ist ferner ein Loch vorgesehen, unterhalb dessen eine Saugdüse sitzt und während der Dauer der Kontaktierung das Bauelement auf der Kontaktplatine festhält.

Fig. 1

Die Erfindung geht aus von einer Prüfvorrichtung für gegurtete elektronische Bauelemente mit den Merkmalen des Oberbegriffs des Anspruchs 1. Eine derartige Prüfvorrichtung ist in der noch nicht veröffentlichten europäischen Anmeldung Nr. 86115585.1 derselben Anmelderin beschrieben und soll hiermit weiterentwickelt werden.

Der im Anspruch 1 angegebenen Erfindung liegt die Aufgabe zugrunde, weitere Vereinfachungen bei der Prüfung von Bauelementen unterschiedlicher Abmessungen zu erreichen.

Die Erfindung hat den Vorteil, daß an der Speicherstation, wo gute Bauelemente zum Ersatz von bei der Prüfung als schlecht klassifizierten Bauelementen zwischengespeichert werden, für Bauelemente unterschiedlicher Abmessungen keine Lagerhaltung spezieller teurer Speicherbehälter erforderlich ist, sondern stattdessen Stücke jeweils des gleichen Gurtes verwendet werden können, in dem die Bauelemente zum Testen kommen und anschließend auch wieder weitergegeben werden. Zu diesem Zweck enthält die Speicherstation ein auf die jeweiligen Gurtabmessungen einstellbares Aufnahmeteil, das gleichzeitig mit der Einstellbewegung des die Greifer für die zu prüfenden Bauelemente tragenden Support für die jeweilige Gurtabmessung eingestellt wird. Dadurch hat das Speichergurtstück, dessen Aufnahmenester für die Bauelemente bei der Verwendung gleicher Gurte ja automatisch passen, auch gleich die richtige Lage für die Entnahme eines guten Bauelementes durch den darüber befindlichen Greifer, der dieses Bauelement nach Weiterschalten in ein leeres Nest des Gurtes mit den zu prüfenden Bauelementen als Ersatz für ein Ausschußelement einsetzt. Die Verwendung gleicher Gurtstücke als Speicher hat ferner den Vorteil, daß nach der Entnahme der Bauelemente beim Anwender die leeren Gurte in genügender Menge als Abfall übrig bleiben, so daß jederzeit genügend Gurtstücke als Speicherbehälter beim Kunden zur Verfügung stehen, der die Bauelemente vor Verwendung einer Eingangsprüfung unterzieht. Im Gegensatz zu anderen, eigens hergestellten Speicherbehältern, die für unterschiedliche Bauelementabmessungen verfügbar sein müßten, kosten diese Gurtstücke nichts und brauchen auch nicht sorgfältig aufgehoben oder vor Verlust bewahrt zu werden.

Die Einstellung des Aufnahmeteils auf den Greifer an der Speicherstation erfolgt zweckmäßigerweise durch eine Verschiebebewegung, die mit der Einstellbewegung des Supports gekoppelt ist und gleichzeitig mit dieser erfolgt, so daß das Aufnahmeteil für das Speichergurtstück automatisch immer ebenso die richtige Stellung für die Gurtabmessungen der gerade geprüften Bauelemente hat, für die auch der Support eingestellt ist.

Eine weitere Vereinfachung durch eine hierbei ebenfalls automatisch vorgenommene Einstellung läßt sich durch eine spezielle Ausgestaltung der Kleberolle für das Wiederversiegeln des Gurtes nach Prüfung der Bauelemente erreichen, indem man die Kleberolle mit mehreren Kleberingpaaren für jeweils verschiedene Gurtabmessungen ausbildet. Man kann dann mit einer einzigen Kleberolle ohne Veränderungen an dieser lediglich durch eine Positionsänderung unterschiedlich breite Gurte versiegeln, und wenn auf einer Kleberolle nicht genügend Klebringpaare unterzubringen sind, dann kann man auch zwei wechselseitig verwendbare Kleberollen mit unterschiedlich angeordneten Klebringpaaren vorsehen. Die axiale Ausrichtung der Kleberollen über dem Gurt läßt sich ohne weiteres mit den Einstell-und Verschiebebewegungen von Support und Aufnahmeteil der Speicherstation koppeln, so daß separate Einstellungen beim Wechsel von Gurten unterschiedlicher Abmessungen sich erübrigen.

Da beim Wechsel des Typs zu prüfender Bauelemente in der Regel auch die Kontaktsätze an der Kontaktierstation ausgewechselt werden müssen, ergeben sich auch hierfür Vereinfachungen und Verbilligungen durch ein Kassettensystem mit auswechselbaren Kontaktkassetten, die in der Herstellung preisgünstig sind und sich leicht und einfach ersetzen lassen. Erfindungsgemäß werden die Kontakte der auswechselbaren Kontaktsätze in gedruckter Schaltung auf einer Platine ausgebildet, die in einem Kassettenrahmen sitzt, welcher seinerseits in die Kontaktierstation derart eingeschoben werden kann, daß er in einer definierten Position sitzt. Die zu testenden Bauelemente werden dann einzeln vom Greifer auf die gedruckten Kontakte abgesetzt und können geprüft werden. Die Andruckkraft für die Kontaktierung kann von einer der Saugdüse des Greifers gegenüberliegend angeordneten Saugdüse aufgebracht werden, die wechselweise mit der Greiferdüse an das Vakuum geschaltet wird und deren Unterdruck durch ein in der Kontaktplatine vorgesehenes Loch das Bauelement ansaugt. Die Verbindungsleitungen der Prüfkontakte zu einer seitlichen Kontaktleiste, mit der die Kontaktkassette an die Prüfelektronik angeschlossen wird, lassen sich so legen, daß ein solches Loch vorgesehen werden kann. Dieses Kassettensystem erlaubt ein sehr schnelles Wechseln der Prüfkontakte bei sicherer Positionierung und Kontaktgabe. Außerdem ist ein Ersatz der Kontaktplatine bei Abnutzung oder Beschädigung preiswert.

Die Erfindung sei nun anhand eines in den Figuren dargestellten Ausführungsbeispiels im einzelnen erläutert. Es zeigen:

Fig. 1 eine schematische Draufsicht auf eine erfindungsgemäß ausgebildete Vorrichtung,

Fig. 2 eine schematische Seitenansicht der in Fig. 1 gezeigten Prüfvorrichtung,

Fig. 3 eine teilweise geschnittene Darstellung zweier Kleberollen in einer einzigen Figur,

Fig. 4 eine schematische Darstellung einer Prüfkassette und

Fig. 5 eine Schnittdarstellung der an der Kontaktierstation vorgesehenen Saugdüsenanordnung zum Festhalten der Bauelemente.

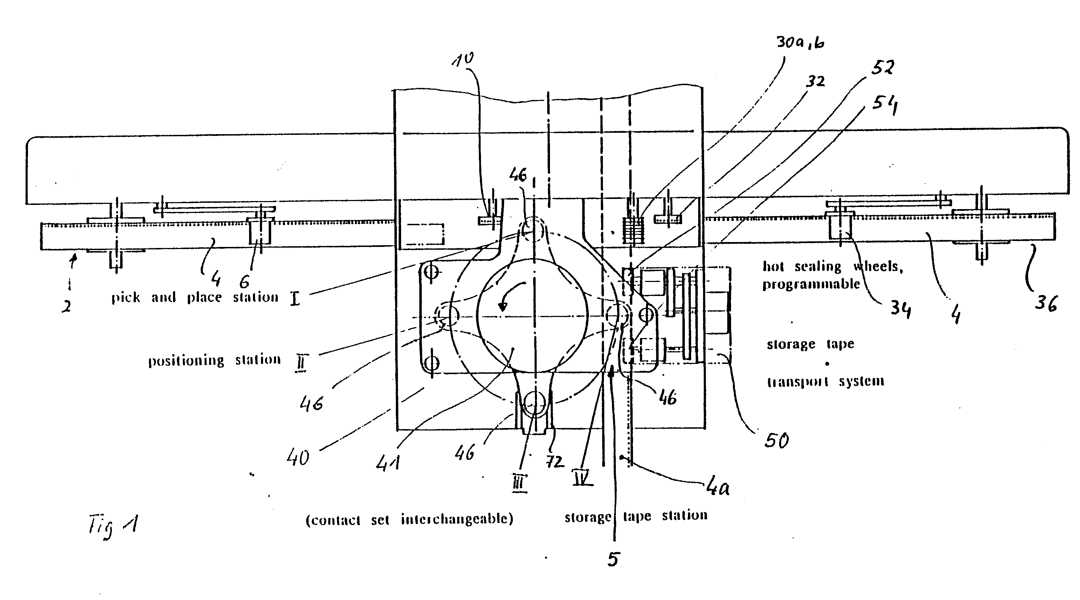

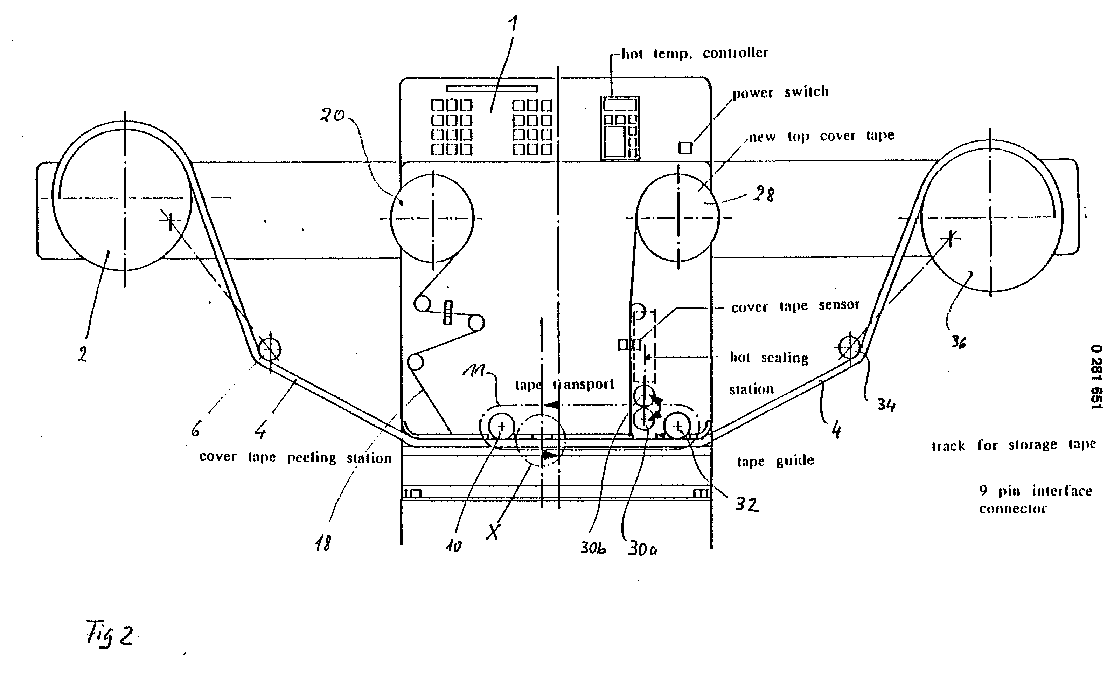

In der in Fig. 1 gezeigten Draufsicht erkennt man einen Gurt (4), der von einer an der Vorrichtung gelagerten Vorratsspule (2) abläuft und über eine Umlenkrolle (6) der eigentlichen Prüfvorrichtung zugeführt wird. Der Gurt hat hier nicht dargestellte Nester, in denen die Bauelemente sitzen und durch ein Deckband (18) festgehalten werden, welches zur Entnahme der Bauelemente abgezogen und auf eine Deckbandspule (20) aufgewickelt wird, wie in Fig. 2 zu erkennen ist, die auch schematisch ein Bedienungsfeld (1) erkennen läßt. Nach dem Prüfen der Bauelemente werden die guten Bauelementen in den Gurt (4) eingesetzt, und es wird ein von einer Deckbandvorratsrolle (28) abgezogenes neues Deckband mit Hilfe einer der beiden Kleberollen (30a, 30b) auf den Gurt aufgesiegelt, und der Gurt wird über eine weitere Umlenkrolle (34) einer Aufwickelspule (36) zugeführt und auf diese aufgewickelt. Das schrittweise Weiterschalten des Gurtes (4) erfolgt mit Hilfe eines Transportsystems mit Zahnrollen (10) und (32), die in eine in Fig. 1 angedeutete Perforation des Gurtes (4) eingreifen und von einem in Fig. 2 angedeuteten Antrieb (11) gemeinsam angetrieben werden.

Fig. 1 läßt ferner einen Support (40) erkennen, der einen Prüfkopf (41) samt Greifern (46) trägt, die hier jedoch nur angedeutet sind. Die Einstellung auf unterschiedliche Gurtbreiten erfolgt durch Verschiebung des Supports (40) gegenüber der hier nicht im einzelnen veranschaulichten Gurtführung, so daß die Saugdüsen der Greifer die einzelnen Bauelemente sicher ansaugen können. Mit I ist in Fig 1 eine Entnahmeposition bezeichnet, an welcher die Bauelemente einzeln aus den Gurtnestern entnommen werden. Der Prüfkopf (41) dreht sich dann um 90° in Pfeilrichtung, so daß das entnommene Bauelement in eine Positionierungsstation II kommt, wo es exakt ausgerichtet wird, ehe es nach einer weiteren 90° Drehung in die Kontaktierposition III transportiert wird und dort die richtige Position zu den Prüfkontakten einnimmt. Nach der elektrischen Prüfung des Bauelementes dreht sich der Prüfkopf (41) wiederum um 90°, so daß das Bauelement zur Speicherstation IV gelangt und im Falle eines schlechten Prüfergebnisses durch ein gutes Bauelement aus dem dortigen Vorrat ersetzt wird, während es im Falle eines guten Prüfergebnisses am Greifer bleibt und nach einer weiteren 90° Drehung in das leere Nest des Gurtes zurückgelegt wird. Nach einem Weitertransport des Gurtes um eine Nestlänge erfolgt die Prüfung des nächsten Bauelementes.

Es wurde bereits erwähnt, daß zur Prüfung unterschiedlicher Bauelemente, die in Gurten unterschiedlicher Abmessungen sitzen, Einstellungsänderungen an der Prüfvorrichtung vorgenommen werden, um auf einer Prüfvorrichtung möglichst viele unterschiedliche Bauelemente prüfen zu können. Um diesen Vorteil auch an der Speicherstation IV besser zu nutzen wird erfindungsgemäß hier auf spezielle Speicherbehälter verzichtet, in denen die zwischengespeicherten Bauelemente in einer Anzahl abgelegt werden, wie sie erfahrungsgemäß zum Ersetzen fehlerhafter Bauelemente in einem Gurt benötigt werden. Anstelle speziell zur Maschine gehöriger Speicherbehälter wird als Zwischenspeicher ein Gurtstück (4a) von gleicher Art wie der Gurt (4) mit den zu prüfenden Bauelementen verwendet. Dieses Gurtstück (4a) wird in ein Aufnahmeteil (5) eingeschoben, das auf einem Hilfssupport (50) sitzt, der an dem Support (40) quer zu dessen Einstellrichtung verschieb bar gelagert ist. Dieser Hilfssupport trägt auch einen Transportmechanismus mit in die Gurtperforation greifenden Transporträdern (52) und (54) zum Weitertransportieren des Gurtstückes (4a) zum nächsten Nest mit einem guten Bauelement nach Entnahme eines solchen als Ersatz für ein schlechtes im Gurt (4).

Durch die Verschiebbarkeit des Hilfssupports (5) läßt sich das im Aufnahmeteil (5) befindliche Gurtstück (4a) so zu dem an der Speicherposition IV befindlichen Greifer (46) einstellen, daß das darunter befindliche Bauelement in gleicher Weise ergriffen werden kann, wie es an der Entnahmeposition (1) der Fall ist. Die rechtwinklig zueinander verlaufenden Einstell-bzw. Verschiebungsbewegungen von Support (40) und Hilfssupport (50) sind miteinander gekoppelt, so daß bei der Einstellung des Supports (40) auf eine bestimmte Gurtabmessung, bei welcher der Greifer in der Position I genau richtig über dem Bauelement sitzt, gleichzeitig der Hilfssupport (50) so eingestellt wird, daß der in der Position IV befindliche Greifer genauso über dem dort befindlichen gespeicherten Bauelement sitzt. Die Koppelung dieser beiden Bewegungen kann über eine geeignete mechanische Führung, etwa mit unter 45° verlaufende Schienen, oder aber auch mit Schrittschaltmotoren, die gleiche Bewegungslängen gewährleisten, erfolgen. Durch eine solche gleichzeitige automatische Einstellung können bei einem Wechsel zwischen Gurten verschiedener Abmessungen keine Einstellvorgänge vergessen werden, was einer Vollautomatisierung zugute kommt. Auch

vereinfacht sich die Einprogrammierung der Gurtdaten bei einer Rechnersteuerung der gesamten Prüfung, bei welcher nur noch die Gurtdaten eingegeben werden müssen und das passende Speichergurtstück eingesetzt werden muß, und die gesamte Prüfung dann automatisch ablaufen kann.

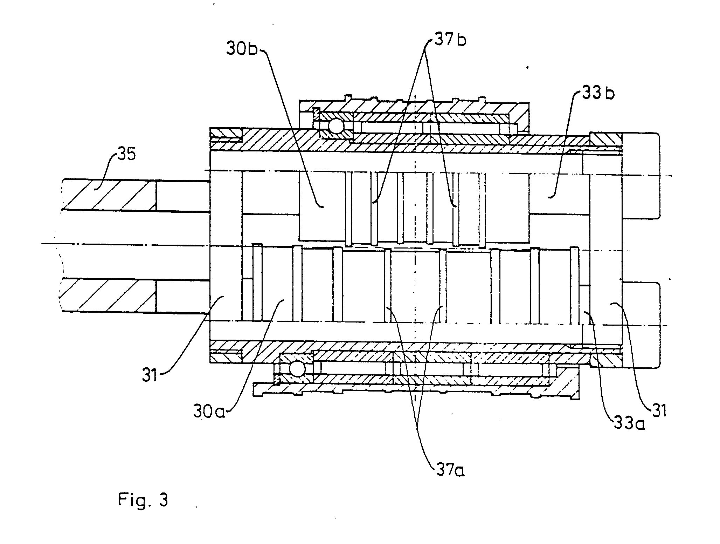

Hierzu gehört auch ein automatisches Wiederversiegeln des Gurtes nach Durchlaufen durch die Prüfstation, und zu diesem Zweck ist die Kleberolle so ausgebildet, daß sie automatisch so mitverstellt werden kann, daß ihre Klebringe zu unterschiedlichen Gurtbreiten paßt. In Fig. 3 ist ein Paar zwei solcher Kleberollen (30a) und (30b) dargestellt, die auf einer Umschaltwippe gelagert sind und sich so abwechselnd in Versiegelungsposition bringen lassen. Die Umschaltwippe ist hier mit zwei Endplatten (31), die durch zwei Lagerachsen (33a) und (33b) für die Klebrollen miteinander verbunden sind, gezeichnet und ist ihrerseits an einer Welle (35) befestigt, die drehbar zum Wechseln der Klebrollen und verschiebbar zur Einstellung der Klebrollen auf die Gurtmitte gelagert ist. Diese Drehung und Verschiebung der Welle (35) erfolgt gekoppelt mit der Supporteinstellung und Hilfssupportverschiebung entsprechend der Programmierung für den jeweiligen Gurt.

Man erkennt an der Klebrolle (30a) vier Klebringpaare, von denen das innerste mit (37a) bezeichnet ist, während die weiter außen liegenden Klebringe der anderen drei Paare der Ubersichtlichkeit halber nicht bezeichnet sind. Wie man sieht, nimmt die Höhe der weiter außen liegenden Klebringpaare gegenüber dem inneren Klebringpaaren zu, so daß der zwischen jeweils zwei benutzten Klebringen liegende Teil des Gurtes von den weiter innen befindlichen Klebringen nicht berührt wird. Da der Gurt nur an beiden Rändern mit der Deckfolie versiegelt wird, befinden sich die weiter außen liegenden - höheren - Klebringe außerhalb der Gurtbreite und stören daher nicht. Die Klebrolle (30a) hat hier vier verschiedene Klebringpaare und eignet sich damit zum Versiegeln von Gurten vier unterschiedlicher Seiten. Die Klebrolle (30b) ist nur mit drei Klebringpaaren versehen, von denen das mittlere mit (37b) bezeichnet ist und die ebenfalls nicht bezeichneten inneren Ringe niedriger, die äußeren Ringe dagegen höher sind. Man sieht ferner, daß die Abstände der Ringe dieser drei Paare zwischen den Ringabständen der Paare der Klebrolle (30a) liegen und somit für weitere verschiedene Gurtbreiten passen. Insgesamt lassen sich mit dem hier gezeichneten Ausführungsbeispiel sieben unterschiedliche Gurtbreiten versiegeln.

Während im mittleren Teil der Figur die Klebrollen (30a) und (30b) in Draufsicht gezeichnet sind, lassen die äußeren Teile der Figur in Schnittdarstellung Einzelheiten der Klebrollenlagerung erkennen. Die Heizung der Klebrollen ist dagegen der einfacheren Darstellung halber nicht veranschaulicht.

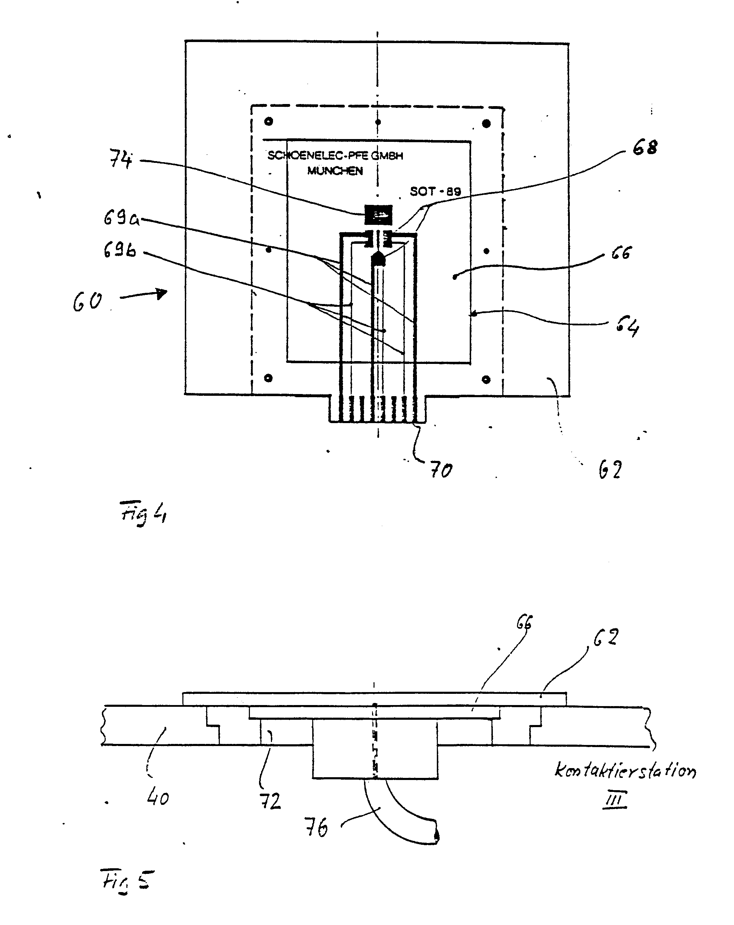

Fig. 4 zeigt eine auswechselbare Kontaktkassette (60), wie sie an der Kontaktierstation III für die Kontaktgabe bei der Bauelementsprüfung verwendet wird. Man erkennt einen Rahmen (62), der beispielsweise aus Metall bestehen kann und einen Ausschnitt (64) zur Aufnahme einer Kontaktplatine (66) enthält, die beispielsweise mit dem Rahmen verschraubt sein kann. Die Kontaktplatine (66) enthält in Form gedruckter Schaltung Kontakte (68), die über ebenfalls gedruckte Zuleitungen (69a) und (69b) zu einer Kontaktleiste (70) führen, an die eine Kontaktkupplung zum Anschließen an die Prüfelektronik ansteckbar ist, wie es bei gedruckten Schaltungsplatinen üblich ist. Von den Zuleitungen zwischen den Kontakten (68) und der Kontaktleiste (70) dienen die dickeren Leitungen (69a) der Stromversorgung des zu prüfenden Bauelementes, während über die dünneren Zuleitungen (69b) die Meßsignale abgenommen werden. Anstelle der drei in Fig. 4 dargestellten Kontakte tritt natürlich bei ICs eine entsprechend größe Anzahl von Kontakten.

Die Kontaktkassette (60) paßt in einen geeigneten Führungsausschnitt (72) an der Kontaktierstation III des Supports (40) und läßt sich für die Prüfung unterschiedlicher Bauelemente leicht gegen eine andere Kontaktkassette austauschen.

In Fig. 4 erkennt man ferner, daß die Kontaktplatine (66) in der Nähe der Kontakte (68) ein Loch (74) aufweist, das sich bei in den Führungsausschnitt (72) eingeschobener Kassette (60) über einer Saugdüse (76) befindet, wie dies in Fig. 5 veranschaulicht ist. Diese Saugdüse (76) wird über ein Ventil dann eingeschaltet, wenn ein Bauelement auf der Kontaktpltine (66) vom Greifer abgesetzt ist und zum Prüfen mit ausgerichteten Kontakten auf der Kontaktplatine festgehalten werden soll. Wenn die untere Saugdüse (76) an das Vakuum geschaltet wird, wird die darüber befindliche Saugdüse des Greifers nach Absetzen des Bauelementes auf der Kontaktplatine entlüftet, so daß die Haltekraft für das Bauelement von der Greifersaugdüse auf die der Fixierung dienende Saugdüse (76) übergeht, die gleichzeitig die erforderliche Kontaktkraft aufbringt.

Nach der Prüfung wird die Vakuumanschaltung dieser beiden Saugdüsen wieder vertauscht, so daß das geprüfte Bauelement von der Greifersaugdüse wieder aufgenommen und vom Greifer zur Speicherstation IV weitertransportiert werden kann.

**Ansprüche**

1. Prüfvorrichtung für gegurtete elektronische Bauelemente mit einer von einer Vorratsspule mit ungeprüften zu einer Fertigspule mit geprüften Bauelementen verlaufenden Gurtführung und einer zwischen diesen Spulen angeordneten Prüfstation, an welcher die Bauelemente nach Lösen eines Deckbandes einzeln mit einem Greifer vom Gurt entnommen, elektrisch geprüft und in den Gurt zurückgelegt werden und schließlich durch ein neues Deckband gesichert werden, wobei der Greifer vier auf dem Umfang eines Kreises angeordnete Greifelemente aufweist, die nacheinander eine Entnahmeposition (I) über dem Gurt und neben dem Gurt eine Ausrichtstation (II), eine Kontaktierstation (III) und eine einen Vorrat guter Bauelemente enthaltende Speicherstation (IV) und - schließlich wieder über dem Gurt eine Gurtbestückungsposition (I) anfährt, und wobei der Greifer auf einem zur Anpassung an unterschiedliche Bauelementabmessungen gegenüber der Gurtführung einstellbaren Support gelagert ist; **dadurch gekennzeichnet,** daß die Speicherstation ein auf unterschiedliche Gurtabmessungen einstellbares Aufnahmeteil (am Hilfssuppurt 50) aufweist, in welches ein als Speicher für den Vorrat guter Bauelemente dienendes gleichartiges Gurtstück (4a) einsetzbar ist, und daß das Aufnahmeteil seinerseits quer zu diesem Gurtstück verschiebbar gelagert und gleichzeitig mit dem Support (50) entsprechend der jeweiligen Gurtbreite verstellbar ist.

2. Prüfvorrichtung nach Anspruch 1, **dadurch gekennzeichnet,** daß das Aufnahmeteil (am Hilfssupport 50) auf dem Support (40) quer zu dessen Einstellrichtung verschiebbar gelagert und in seiner Verschiebungsbewegung mit der Einstellbewegung des Supports gekoppelt ist.

3. Prüfvorrichtung nach Anspruch 1, **dadurch gekennzeichnet,** daß zum Aufsiegeln eines neuen Deckbandes (von der Vorratsrolle 28) zwischen den Transportrollen (10, 32) und der Gurtführung mindestens eine zusammen mit den Einstell- und Verschiebebewegungen auf die jeweilige Gurtbreite zentrierbare, heizbare Kleberolle (30a,b) mit paarweise angeordneten erhöhten Klebringen (37a, 37b) vorgesehen ist, deren jedes Paar einer bestimmten Gurtbreite zugeordnet ist und deren äußere jeweils höher als die inneren sind.

4. Prüfvorrichtung nach Anspruch 3, **dadurch gekennzeichnet,** daß auf einer Umschaltwippe (31, 33a,b) zwei Klebrollen (30a, 30b) mit unterschiedlichen Klebringpaaren (37a) bzw. (37b) angeordnet und wahlweise in die Versiegelungsposition bringbar sind.

5. Prüfvorrichtung nach Anspruch 1, **dadurch gekennzeichnet,** daß die Kontaktierstation (III) Kontaktstücke in Form auswechselbarer Kontaktkassetten (60) mit einer Kontaktplatine (66) mit aufgedruckten Kontakten (68) und Zuleitungen (69a, b) nebst Anschlußkontaktleiste (70) aufweist.

6. Prüfvorrichtung nach Anspruch 5, **dadurch gekennzeichnet,** daß die Greifelemente an Unterdruckleitungen angeschlossene, über Ventile anschaltbare Saugdüsen aufweisen und unterhalb der Kontaktplatine (66) eine weitere, mit einer zugeordneten Platinenöffnung (64) ausgerichtete und den Kontaktdruck bestimmende Saugdüse (76) angeordnet ist, deren Ventil wechselseitig mit dem Ventil der gerade an der Kontaktierstation befindlichen Saugdüse einschaltbar ist.

30a,b

32

52

54

10

46

0 281 651

hot sealing wheels, programmable

pick and place station I

4 6

2

34

4

36

positioning station II

storage tape

transport system

46

50

40

41

46

72

4a

III

IV

Tig 1

(contact set interchangeable)

storage tape station

5

1

hot temp. controller

power switch

new top cover tape

20

28

cover tape sensor

hot sealing

station

tape transport

2

M

6    4

cover tape peeling station

18    10    X    30b  30a

32

tape guide

36

34

4

track for storage tape

9 pin interface
connector

0 281 651

Fig 2

Fig. 3

Fig 4

Fig 5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | US-A-4 324 600 (K.E. BANKES et al.) <br> * Spalte 1, Zeile 18 - Spalte 3, Zeile 48 * | 1 | B 07 C 5/344 <br> G 01 R 31/28 |
| A | US-A-4 506 213 (B. O'CONNOR) <br> * Spalte 2, Zeilen 30-45 * | 1 | |
| A | US-A-3 543 158 (G.O. STEGNER) <br> * Anspruch 1; Figur 1 * | 5 | |
| A | US-A-3 234 496 (N.J. CEDRONE) <br> * Figuren 1-10 * | 5 | |
| A | US-A-3 750 878 (R.D. ATCHLEY et al.) <br> * Figuren 4, 5 * | 6 | RECHERCHIERTE SACHGEBIETE (Int. Cl.4) |
| A | DE-A-3 336 972 (K. KOHLS PRÄZISIONSWERKZEUG UND MASCHINENBAU) <br> * Anspruch 2; Figur * | | B 07 C 5/344 <br> G 01 R 1/073 <br> G 01 R 31/28 <br> H 05 K 13/08 |

Der vorliegende Recherchenbericht wurde für alle Patentansprüche erstellt.

| Recherchenort | Abschlußdatum der Recherche | Prüfer |
|---|---|---|
| BERLIN | 28-10-1987 | LEMMERICH J |

KATEGORIE DER GENANNTEN DOKUMENTE
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82